# EUROPÄISCHE PATENTSCHRIFT

(11) **EP 2 639 842 B1**
(45) Veröffentlichungstag und Bekanntmachung des Hinweises auf die Patenterteilung: **04.06.2014**
(21) Anmeldenummer: 13002171.0
(22) Anmeldetag: 28.06.2011
(51) Int. Cl.: H01L 41/09, H01L 41/047, H02N 2/02

(54) **Gerät zur Präzisionsverschiebung**
Apparatus for precision displacement
Appareil de déplacement de précision

(30) Priorität: 01.06.2011 WO PCT/EP2011/002706
(43) Veröffentlichungstag der Anmeldung: 18.09.2013
(62) Teilanmeldung aus: 11758374.0
(73) Patentinhaber: Potemkin, Alexander, 22885 Barsbüttel (DE); Luskinovich, Petr, Nikolaevich, Moscow 127562 (RU); Zhabotinsky, Vladimir, Alexandrovich, Moscow 123098 (RU)
(72) Erfinder: Potemkin, Alexander, 22885 Barsbüttel (DE); Luskinovich, Petr, Nikolaevich, Moscow 127562 (RU); Zhabotinsky, Vladimir, Alexandrovich, Moscow 123098 (RU)
(74) Vertreter: Säger, Manfred

(56) Entgegenhaltungen:
- WO-A1-2006/083191
- US-A- 4 384 230
- US-A- 5 438 469
- US-A- 5 714 832
- JIANG X ET AL: "Cryogenic actuators and motors using single crystal piezoelectrics", ADVANCES IN CRYOGENIC ENGINEERING; AIP CONFERENCE PROCEEDINGS, Bd. 823, 2006, Seiten 1783-1789, XP055035107, ISSN: 0094-243X, DOI: 10.1063/1.2202607
- KLEIMAN R N: "Single-crystal fine-positioning devices for scanned-probe microscopies", MRS PROCEEDINGS, Bd. 406, 1995, Seiten 221-226, XP055034934, ISSN: 0272-9172, DOI: 10.1557/PROC-406-221

## Beschreibung

Die Erfindung betrifft ein gattungsgemäßes Gerät zur Präzisionsverschiebung. Die Erfindung gehört zum Bereich des Feingerätebaus und kann für genaue Verschiebungen und lineare Größen im Nanometerbereich als auch als Kalibrierstandadrd für Profilometer verwendet werden.

Bekannt ist ein Gerät zur Präzisionsbewegung, das eine lineare Verschiebung im Nanobereich (US 4787148) gewährleistet. Das bekannte Gerät ist seinem Wesen nach eine Verbesserung des bekannten Mikrometers, das über einen zweistufigen mechanischen Reduzierer mit entsprechendem Übertragungswert versorgt wird.

Nachteil des bekannten Gerätes sind die relativ geringe Genauigkeit der eingegebenen Verschiebung und die geringe Reproduzierbarkeit der Ergebnisse, und zwar im Ergebnis wegen einer Hysterese und eines Werkstoffs mit Kriechdehnung.

Bekannt ist ein genauer arbeitendes Gerät, das zur Prüfung von Profilometern und Rastersondermikroskopen verwendet wird. Dieses Gerät weist eine monokristalline Platte auf, in der in mikroelektronischer Technologie stufenweise Vertiefungen ausgeführt sind, wobei jede Stufe mit identisch fixierter Höhe ausgeführt ist (US 6028008).

Die Übertragung des linearen Wertes mithilfe eines solchen Gerätes kann aufgrund der Streuung seiner Ausführung in der Serie nur bei einer Durchführung vielfacher Messungen in verschiedenen Oberflächenbereichen und mit anschließender mathematischer Bearbeitung der Ergebnisse der Messungen realisiert werden.

Dieses Gerät ist von bestimmten Mängeln gekennzeichnet. Mit seiner Hilfe können lineare Verschiebungen nur in einer Richtung, nämlich in die Tiefe, gemessen werden. Wenn außerdem für die Ausführung die Ätzmethode angewendet wird, kann die Genauigkeit der Ausführung der Stufenhöhe einige Atomschichten bilden und in Anbetracht dessen, dass der Parameter des Kristallgitters für Silicium gleich 0,5 nm ist, so wird die Nichtbestimmbarkeit der Stufenhöhe 5 - 7 nm betragen, was für eine Reihe von Anwendungen unbrauchbar ist.

Ähnliche Geräte in Form einer Vertiefung eines unterschiedlich breiten Nanometerbereiches werden zur Kalibrierung auf einer Ebene verwendet. Doch erfordert deren Ausführung den Einsatz nanotechnologischer Prozesse.

Ein Mangel dieser Geräte ist die Instabilität ihrer Masse durch Verstaubung, die Ausfällung einer adsorbierten Schicht an der Oberfläche und den Verlauf physikalisch-chemischer Prozesse wie Migration, Diffusion und Oxidation.

Präzisionsstapelaktoren aus piezoelektrischen Werkstoffen mit dazwischen liegenden Elektroden aus elastischen Materialien sind etwa aus US 4,384,230 oder X. JIANG et al "Cryogenic actuators and motors using single crystal piezoelectrics" AIP CONFERENCE PROCEEDINGS, vol. 823, pages 1783-1789, 2006 (XP055035107) bekannt.

US 5,438,469 lehrt eine Vorrichtung zur Präzisionsverschiebung eines Magnetkopfes mit einem oder mehreren Piezoelementen zwischen einer L-förmigen Basis und einer T-förmigen Konsole.

Nahe kommt der Erfindung auch das gattungsgemäße Gerät zur Präzisionsbewegung, das Elektroden enthält, die auf dem Boden einer Platte aus piezoelektrischem Werkstoff befestigt sind und die auf zwei ihr entgegengesetzt liegenden Seiten aufgetragen und an einer elektrischen Spannungsquelle angeschlossen sind (WO 2006/083191 A1).

Ein Mangel dieses bekannten Gerätes ist die Instabilität der Parameter des Gerätes, insbesondere die mangelnde Langzeitstabilität bei seiner Nutzung.

Der Erfindung liegt deshalb die Aufgabe zugrunde, das gattungsgemäße Gerät mit besserer Stabilität im Betrieb auszugestalten. Diese Aufabe wir durch den Gegenstand der Ansprüche gelöst.

Die bei der Erfindung beschriebenen Geräten zur Präzisionsbewegung dienen zur Einhaltung der Parameter im Betrieb und zur Reduzierung der Nichtbestimmbarkeit des Maßes der Verschiebung.

Alle beschriebenen Geräte zur Präzisionsbewegung beruhen auf einem physikalischen Prinzip der gesteuerten Änderung der geometrischer Abmessung der Platte aus piezoelektrischem Werkstoff, und zwar im Ergebnis dessen, dass an diese eine elektrische Spannung angelegt wird. Dadurch dass die Elektroden elastisch unter Bildung eines Basismoduls ausgebildet sind, ergeben sich in dem Bereich zwischen diesen und den damit verbundenen Oberflächen wie jene eines Bodens oder Lese- oder Schutzschicht bzw. -ebene keine störenden und verfälschenden mechanischen Spannungen. Dieses Basismodul kann in den verschiedenen Ausführungsformen der Erfindung eingestzt werden.

Alle beschriebenen Ausführungsformen der Erfindung zielen auf das wiederholbare präzise Erreichen ein und desselben technischen Ergebnisses sowie der Gewährleistung der Parameter im Betrieb und der Reduzierung der Nichtbestimmbarkeit der Verschiebung.

Dies wird dadurch erreicht, dass sowohl bei einer ersten Ausführungsform des erfindungsgemäßen Gerätes zur Präzisionsbewegungen als auch beim Gegenstand der weiteren Ausführungen eine mit dem Boden verbundene Platte aus piezoelektrischem Werkstoff enthalten ist, auf die auf zwei entgegengesetzt liegenden parallelen Seiten Elektroden aufgetragen sind, die an eine elektrische Spannungsquelle angeschlossen sind, die beim Anlegen der Gleichspannung an die Elektroden die Änderung der Abmessung sowie der Form der Platte in rechtwinkliger oder paralleler Richtung zu der Ebene der Elektroden gewährleisten, wobei sich zwischen der genannten Platte aus piezoelektrischem Werkstoff und dem Boden mehrere identische Platten befinden, zwischen denen elastische Elektroden verteilt sind, an die Spannungen (+U) von jeweils gleicher Größe und Richtung angelegt sind.

Das genannte Ergebnis wird auch dadurch erreicht, dass die Platten aus einem Werkstoff mit kleinen Hysteresen ausgeführt sind.

Das genannte Ergebnis wird auch dadurch erreicht, dass die Platten aus einem Werkstoff mit geringer Kriechdehnung ausgeführt sind.

Ein Mangel des Gegenstand der Erfindungs im Verhältnis zur ersten Ausführungsform des vorgeschlagenen Gerätes ist die Instabilität der Einhaltung der Betriebscharakteristika. Das wird dadurch erklärt, dass bei Anlagen einer Spannung an die Elektroden eine Änderung der geometrischen Maße der Platte aus piezoelektrischem Werkstoff einschließlich der Umgebung erfolgt, die sich auf dem Boden befindet, die ihre Maße nicht ändert. Gleichzeitig führt eine Änderung der geometrischen Maße der Platte bei einer Unveränderlichkeit der Abmessungen der Umgebung des Kontaktes mit dem Boden zur Entstehung von Kräften, die auf die Verschiebung der Platte im Verhältnis zum Boden ausgerichtet sind, was zu einer elastischen und unelastischen Deformierung und zur Änderung der Arbeitscharakteristika führt.

Die Ausführungsform des Gerätes zur Präzisionsbewegung in Form der Aufnahme einiger Platten aus piezoelektrischem Werkstoff erlaubt es, an jede der Platten eine geringere Spannung anzulegen, wodurch die notwendige summarische Verschiebung des Gerätes in Richtung der rechtwinkligen oder entsprechend ausgerichteten Ebene der Elektroden gewährleistet wird.

Wenn zwischen den Platten elastische Elektroden angeordnet werden, werden sie keinen Einfluss auf die Änderung der geometrischen Abmessungen jeder der Platten haben und es werden infolgedessen keine mechanischen Spannungen entstehen, und zwar weder im Bereich des Kontaktes mit dem Boden noch untereinander, was praktisch zu Nullkräften auf der Platte führen kann. Auf diese Art werden sich die Parameter des Gerätes im Prozess der Nutzung weniger ändern, und die Betriebsdauer des Gerätes mit Einhaltung seiner Betriebsparameter verlängert sich wesentlich im Sinne einer Langzeitpräzision.

Am zweckmäßigsten ist es, die Platten aus Werkstoff mit kleiner Hysterese (nicht eindeutiger schleifenförmiger Abhängigkeit der Polarisierung der Ferrodielektrizität vom äußeren elektrischen Feld E bei seiner zyklischen Änderung) und einer Kriechdehnung (der Verzögerung der Reaktion auf die Änderung des Wertes des gesteuerten elektrischen Feldes) auszuführen.

In diesem Fall wird die Unbestimmbarkeit der gesteuerten Änderung geometrischer Maße jeder dieser Platten geringer und die Stabilität der Parameter größer. Die Ausführung des Gerätes zur Präzisionsbewegung in Form von Platten aus piezoelektrischem Werkstoff mit kleiner Hysterese und Kriechdehnung mit Elektroden, die auf zwei ihr entgegengesetzt liegenden Seiten aufgetragen und an Spannungsquellen angeschlossen sind, erlauben bei Anlegen einer Spannung an die Elektroden die Gewährleistung der Wiederholbarkeit äußerst kleiner, gering bestimmbarer Verschiebungen der piezoelektrischen Platte. Dementsprechend kann bei Einstellung einer gewünschten Nichtbestimmbarkeit der Messung auch ein passender Werkstoff ausgewählt werden, der eine entsprechende Hysterese aufweist, die das gewährleistet. Die geringste Hysterese und Kriechdehnung bei einem umgekehrt verlaufenden piezoelektrischen Effekt besitzen Monokristalle, weshalb es am zweckmäßigsten ist, die Platte aus monokristallinem piezoelektrischem Werkstoff auszuführen.

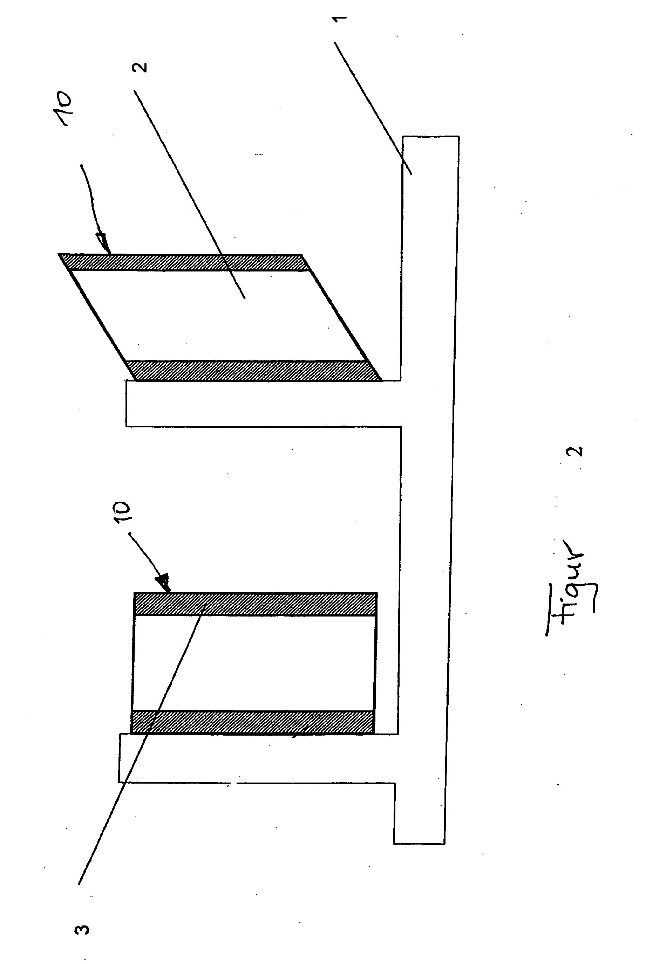

Ein Mangel des bekannten Gerätes, das als Gegenstand der Erfindung im Verhältnis zu der zweiten Ausführungsform ausgewählt wurde, ist ein relativ geringer Bereich der Verschiebung in vertikaler Ebene (in Richtung rechtwinklig zu der Ebene der Elektroden), was den Einsatzbereich begrenzt. Die Vergrößerung der geometrischen Abmessung der Platte aus piezoelektrischem Werkstoff hat, um den Bereich der Verschiebung in einer vertikalen Ebene zu vergrößern, die Notwendigkeit der Erhöhung der Spannung zur Folge, die an die Elektroden angelegt wird, was in vielen Fällen äußerst unerwünscht ist und zur Instabilität der Arbeitscharakteristika führen kann. Wird eine solche Platte aus piezoelektrischem Werkstoff mit solchen Elektroden genommen, die auf zwei entgegengesetzt liegenden, parallelen Seiten aufgetragen und an eine Spannungsquelle angeschlossen sind und so ausgeführt sind, dass sie beim Anlegen einer Spannung die Elektroden die Änderung der Maße der Platte in der Richtung gewährleisten, die parallel zur Ebene der Elektroden liegt, kann die Verteilung um ein Vielfaches größer sein. Auch wenn eine solche Platte auf dem Boden so befestigt wird, dass die Elektroden vertikal dazu verlaufen, verändern sich bei Anlegen der Spannung die geometrischen Maße der Platte so, dass sie sich aus einem rechtwinkligen Parallelepiped in ein geneigtes Prisma verändert (Figur 2).

Die Ausführung des Gerätes zur Präzisionsbewegung in Form einer Platte aus piezoelektrischem Werkstoff, auf der auf zwei ihr gegenüberliegenden parallelen Seiten Elektroden aufgetragenen sind, die an Spannungsquellen angeschlossen sind und bei Anlegen der Spannung an die Elektroden die Änderung der Maße der Platte in Richtung der parallelen Ebene der Elektroden und die Befestigung der Platte, die mit einer der Elektrode auf der vertikalen Fläche und mit dem Boden der Konsole verbunden ist, und mit der zweiten Elektrode, die mit der Lesefläche der Konsole mit vertikaler Fläche der parallelen Ebene dieser Elektrode verbunden ist, erlaubt eine wesentliche Vergrößerung des Bereich der Verschiebung in Richtung der vertikalen Ebene. Tatsächlich gewährleistet die vorgeschlagene Ausführungsform der Ausgestaltung der Platte aus piezoelektrischem Werkstoff, auf die auf zwei ihr gegenüberliegende parallele Seiten Elektroden aufgetragen sind, die an Spannungsquellen angeschlossen sind und die beim Anlagen der Spannung an die Elektroden die Änderung der Maße der Platte in Richtung parallel zur Ebene der Elektroden bewirken, einen großen Bereich der Verschiebung in Richtung der Ebene der Elektroden. Dadurch gewährleistet die Ausführungsform mit der Platte aus piezoelektrischem Werkstoff, auf die auf ihr zwei gegenüberliegenden parallelen Seiten Elektroden aufgetragen sind, die an Spannungsquellen angeschlossen sind, beim Anlagen der Spannung an die Elektroden die Änderung der Maße der Platte in Richtung rechtwinklig zu der Ebene der Elektroden.

Die Ausrüstung des Gerätes erfolgt teilweise durch Ausgestaltung einer zweiten Platte aus piezoelektrischem Werkstoff, die identisch der ersten ist und deren Befestigung so, dass eine Elektrode an einer Konsole befestigt wird, die mit der Lesefläche verbunden ist, und zwar auf deren vertikaler Fläche, die der gegenüber liegt, auf der die erste Platte befestigt ist; die zweite Elektrode ist mit der vertikalen Fläche der dritten Konsole verbunden, die mit dem Boden verbunden ist, was eine Kompensierung der seitlichen Verschiebung der Konsole mit der Lesefläche (infolge gleicher und gegenüberliegend ausgerichteter seitlicher Verschiebungen der Piezoplatten), die Vergrößerung der Biegefestigkeit der Konstruktion und die Kriechdehnung gegenüber äußeren Vibrationen erlaubt. Am zweckmäßigsten ist es, zur Reduzierung unbestimmbarer Verschiebungen die Platte aus monokristallinem Werkstoff mit geringer Hysterese und Kriechdehnung auszuführen.

Bei einer weiteren nicht erfindungsgemäßen Ausführungsform der Ausgestaltung des Gerätes wird das genannte Ergebnis dadurch erzielt, dass das Gerät zur Präzisionsbewegung eine mit dem Boden verbundene Platte aus piezoelektrischem Werkstoff enthält, auf der auf zwei ihr gegenüberliegenden parallelen Seiten Elektroden aufgetragen sind, die an Spannungsquellen angeschlossen sind und die beim Anlegen der Spannung eine Änderung der Maße der Platte in Richtung rechtwinklig zu der Ebene der Elektroden gewährleisten, wobei die Platte mit der oberen Elektrode auf der unteren horizontal bezüglich des Bodens verlaufenden Fläche einer L-förmigen ersten Konsole befestigt ist. Die untere Elektrode des Basismoduls ist mit dem unteren Bereich (ersten U-Schenkels) einer U-förmigen zweiten Konsole und die untere Elektrode des weiteren Basismoduls ist mit der oberen horizontalen Fläche des oberen Bereichs des horizontal geführten zweiten U-Schenkels der zweiten Konsole verbunden, wobei auf deren oberer Elektrode sich die Lesefläche befindet.

Das genannte Resultat wird auch nur dadurch erzielt, dass die Platten aus einem Werkstoff mit kleiner Hysterese ausgeführt sind.

Das genannte Ergebnis wird auch nur dadurch erzielt, dass die Platten aus Werkstoff mit geringer Kriechdehnung ausgeführt sind.

Ein Mangel des bekannten Gerätes im Verhältnis zu der weiteren Ausführungsform besteht darin, dass im Ergebnis der Änderung der Umgebungstemperatur und auch durch die seitliche Verschiebung der Platte sowie beim Anlegen der Regelspannung eine Änderung der geometrischen Maße der Platte möglich ist. Der genannte Umstand hat negativen Einfluss auf die Einhaltung der Parameter des Gerätes im Betrieb und der Unbestimmbarkeit der Verschiebung.

Die Befestigung der ersten Platte mit der oberen Elektrode auf der unteren horizontalen Fläche der ersten Konsole und der unteren Elektrode auf der oberen horizontalen Fläche des unteren Kopfstückes (Unterer U-Schenkel der zweiten Konsole) der horizontal eingestellten U-förmigen Konsole und die Befestigung der mit der ersten bezüglich der zweiten identischen Platte mit deren unterer Elektrode auf der oberen Fläche des oberen Kopfstücks (oberer U-Schenkel der zweiten Konsole) der zweiten Konsole erlauben die Beseitigung des Einflusses der Änderung der geometrischen Maße der Platte, und zwar im Ergebnis der seitlichen Verschiebung aufgrund der Regelspannung und der Änderung der Umgebungstemperatur auf die Verschiebung der Lesefläche. Wenn sich das Gerät (und entsprechend beide Platten) tatsächlich im sich ändernden Temperaturfeld oder unter Einwirkung der Regelspannung befinden, so wird sich bei Dehnung der ersten (unteren) Platte das untere Kopfstück der U-förmigen zweiten Konsole, auf der es befestigt ist, nach unten verschieben, was auch die Verschiebung des oberen Kopfstücks der U-förmigen zweiten Konsole zur Folge hat. Die zweite darauf befestigte Platte dehnt sich ebenfalls und zieht die Lesefläche auf eben diesen Abstand nach oben, auf den die U-förmige Konsole nach unten verschoben wird, wobei die seitliche Verschiebung der ersten (unteren) Platte erfolgt, was eine Temperaturkompensation zur Folge hat.

Bei einer noch anderen nicht erfindungsgemäßen Ausführungsform des Gerätes wird das genannte Ergebnis dadurch erzielt, dass das Gerät zur Präzisionsbewegung eine Platte aus piezoelektrischem Werkstoff enthält, die sich auf dem Boden befindet, auf der auf zwei ihr gegenüberliegenden parallelen Seiten die Elektroden aufgetragen sind, die an die Spannungsquelle angeschlossen sind, die beim Anlegen der Spannung an die Elektroden die Änderung der Maße der Platte in rechtwinkliger Richtung oder paralleler Ebene der Elektroden gewährleisten, wobei sich auf der Ebene der Platte in mehrere Teile aufgeteilte Elektroden mit Zwischenräumen befinden und die Elektroden aller Teile an die allgemeine Spannungsquelle angeschlossen sind, wobei sich über den Platten ein sie alle bedeckender Träger mit einer Lesefläche befindet, dessen Temperaturkoeffizient der Dehnung gleich dem Temperaturkoeffizienten der Dehnung des Bodens ist.

Das genannte Ergebnis wird auch dadurch erzielt, dass die Platten aus einem Werkstoff mit geringer Kriechdehnung ausgeführt sind.

Genüber den anderen Ausführungsformen ist der Vorteil der vorstehend geschilderten jener, dass der Boden und die Platte aus piezoelektrischem Werkstoff keine unterschiedliche Koeffizienten der thermischen Dehnung aufweisen, weshalb bei Änderung der Temperatur keine mechanische Spannungen entstehen, die Kräfte zur Folge haben, welche wegen der Verschiebung der Platte im Verhältnis zum Boden im Bereich ihrer Befestigung zu mechanischen Spannungen führen, die zu Änderungen deren Betriebscharakteristika und zum mechanischen Abriss führt. Wird die Platte in mehrere Teile gesplittet, entstehen unter diesen Bedingungen, außer der, dass die Kontaktfläche eines jeden Teiles an den Elektroden kleiner wird als bei einer ganzen Platte, Kräfte, die auf die Verschiebung der Platte im Verhältnis zum Boden wirken, und zwar hervorgerufen durch verschiedene Koeffizienten der thermischen Dehnung des Bodens und der Platte aus piezoelektrischem Werkstoff, die auch kleiner werden. Auf diese Weise bleibt das Gerät unter Einhaltung seiner Arbeitscharakteristika wesentlich länger stabil in Betrieb.

Das Abdecken der Platte mit einem Träger gewährleistet eine Erhöhung des Schutzes im Prozess der Nutzung durch Erhöhung der Stabilität gegenüber äußeren mechanischen Einwirkungen, der mechanischen Stabilität des Gerätes zur Präzisionsbewegung und eine gleichmäßige Verteilung der äußeren Beladung. Der Träger muss mit einem Temperaturkoeffizienten der Dehnung ausgeführt werden, der gleich dem Temperaturkoeffizienten der Dehnung des Bodens ist, und zwar deshalb, um mechanische Spannungen auf die Elektroden der oberen und unteren Fläche der Platte bei Änderung des Temperaturbereiches zu vermeiden.

Bei der letzten nicht erfindungsgemäßen Ausführungsform der Ausgestaltung des Gerätes wird das genannte Ergebnis dadurch erzielt, dass das Gerät zur Präzisionsbewegung auf dem Boden der Platte aus piezoelektrischem Werkstoff mit zwei auf deren entgegengesetzt liegenden parallelen Seiten Elektroden enthält, die an eine Spannungsquelle angeschlossen sind und beim Anlegen der Spannung an die Elektroden die Änderung der Maße der Platte in Richtung der rechtwinkligen oder parallelen Ebene der Elektroden gewährleisten, wobei die Platte mit Elektroden ausgeführt ist, die in der Ebene in mehrere Teile mit Zwischenabständen aufgeteilt sind; die Elektroden aller Teile sind an die allgemeine Spannungsquelle angeschlossen, wobei sich über den Platten zwei Träger mit Leseflächen mit Zwischenräumen befinden, die die Platten bedecken und einen Temperaturkoeffizienten der Dehnung haben, die gleich dem Temperaturkoeffizienten der Dehnung des Bodens sind.

Das genannte Ergebnis wird auch dadurch erzielt, dass die Platten aus einem Werkstoff mit geringer Hysterese ausgeführt sind.

Das genannte Ergebnis wird auch dadurch erzielt, dass die Platten aus einem Werkstoff mit geringer Kriechdehnung ausgeführt sind.

Das genannte Ergebnis wird auch dadurch erzielt, dass sich auf der oberen Lesefläche mindestens eine Markierung des Wertes von einem Atom eines Stoffes bis zu einigen hundert Nanometer befindet.

Das Abdecken der Platte mit zwei Trägern mit Zwischenräumen gestattet es, bei der Messung der entsprechenden gesteuerten Verschiebung der oberen Leseflächen den Einfluss einer thermischen Dehnung der Platte auszuschließen und die Messdauer zu verkürzen, was zur einer Verringerung des Einflusses einer langsamen Änderung der Lage des Messinstrumentes unter Mitwirkung einer Wärmedrift, einer mechanischen Relaxation usw. führt.

Das Wesen des beschriebenen Gerätes zur Präzisionsbewegung wird anhand von Beispielen seiner Ausgestaltung und den beiliegenden Zeichnungen erläutert:
In Abb. 1 ist schematisch und vereinfacht die allgemeine Ansicht des Gerätes dargestellt.
In Abb. 2 sind die Phasen der Arbeit der Platte aus piezoelektrischem Werkstoff und die Deformierung ihrer Form bei einer Verschiebung in Richtung der parallelen Ebene der Elektroden dargestellt.
In Abb. 3 ist schematisch und vereinfacht die allgemeine Ansicht des Gerätes in der erfindungsgemäßen Ausführungsform der Ausgestaltung dargestellt.
In Abb. 4 ist schematisch und vereinfacht die allgemeine Ansicht des Gerätes in der Ausführungsform gemäß Figur 3 mit zwei Platten aus piezoelektrischem Werkstoff dargestellt.
In Abb. 5 ist eine Ansicht des Gerätes einer weiteren Ausführungsform dargestellt.
In Abb. 6 ist eine Ansicht des Gerätes einer noch anderen Ausführungsform dargestellt.
In Abb. 7 ist schematisch und vereinfacht die allgemeine Ansicht des Gerätes in einer letzten Ausführungsform dargestellt.

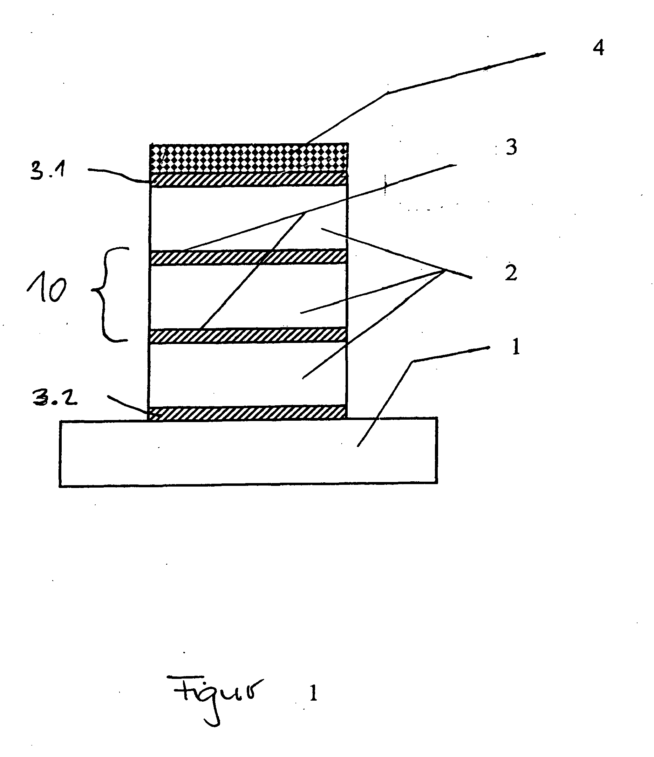

Beispiel 1. Das Gerät zur Präzisionsbewegung (Abb. 1), verwendbar in den erfindungsgemäßen Beispielen 2 und 3, enthält einen Boden 1, auf dem eine Gruppe Platten aus piezoelektrischem Werkstoff 2 befestigt ist, die durch Elektroden 3 getrennt sind und jeweils ein Basismodul 10 bilden. Auf der oberen festen, nicht elastischen Elektrode 3.1 der oberen Platte kann eine Lese- oder Schutzfläche oder -ebene 4 aufgetragen werden. Die unterste Platte 2 ist ebenfalls über eine feste, nicht elastischen Elektrode 3.2 an dem Boden 1 festgelegt.

Piezoelektrischer Werkstoff kann ein beliebiger auch polykristalliner Werkstoff sein. Doch am zweckmäßigsten ist die Verwendung von Monokristallen mit geringer Hysterese und Kriechdehnung. Es können also Monokristalle von Lithiumniobat, Strontium-Barium-Niobat, Barium-Natrium-Niobat und andere Kristalle mit Piezoeffekt verwendet werden. Auf zwei entgegengesetzt liegenden Seiten der Platte 2 werden mit bekannten Verfahren elastische Elektroden 3 mit einer Dicke unter 0,5 µm aufgetragen. Als Elektrodenmaterial wird am zweckmäßigsten Cr, Cu oder In verwendet. Auf die Fläche der oberen der Elektroden wird eine Lese- oder Schutzschicht bzw. -ebene 4 aus Saphir oder aus diamantähnlichem Werkstoff aufgetragen.

Das Gerät wird wie folgt verwendet:
Zu Beginn wird die Abhängigkeit der Änderung der Maße des Gerätes zur Präzisionsbewegung von der an die Elektroden angelegten jeweils gleich gepolten und gleich großen Spannung gemessen, d.h. es wird eine Skalierungsgrafik generiert. Die Generierung einer Skalierungsgrafik erfolgt durch Anlegen einer Feststellungsspannung an die Elektroden des Gerätes und durch Messen der entsprechenden Verschiebung der Lese- oder Schutzschicht bzw. -ebene 4 der Gruppe piezoelektrischer Platten in Form des Basismoduls.

Die Messung der Verschiebung erfolgt nach bekannten Methoden mithilfe des Bereiches 3D eines Laser gestützten interferometrischen Systems zur Messung von Nanobewegungen (auf Basis eines Atomkraftmikroskops und drei Laser-Interferometern).

Zur Messung einer Verschiebung der rechtwinkligen Fläche zu den Elektroden muss das Gerät im System zur Messung von Nanobewegungen angeordnet werden. Die Mikroskopsonden sind zur Fläche des Gerätes mit einem Abstand heranzuführen, bei dem das Stabilisierungssystem arbeitet. An das Gerät ist Spannung anzulegen und der Abstand zu messen, um den die Ebene 4 des Gerätes beim Anlegen der Spannung verschoben worden ist. Anschließend ist der Wert der angelegten Spannung zu ändern und erneut der Wert der Verschiebung der Oberfläche des Gerätes zu messen.

Im Ergebnis mehrerer Messungen der Verschiebung, die mit verschiedenen Spannungswerten ausgeführt werden, ist eine Ergebnistabelle der experimentellen Messungen zu erstellen, auf deren Grundlage eine Skalierungsgrafik der Abhängigkeit des Wertes der Verschiebung der Fläche des Gerätes in Richtung der rechtwinkligen Fläche der Elektroden vom Wert der angelegten Spannung generiert wird.

Mithilfe des Gerätes können unterschiedliche Messapparaturen skaliert werden.

Zur Skalierung jedweder Gruppen (zum Beispiel eines Sondenmikroskops) entlang der Normalen zur untersuchten Fläche wird das empfohlene Gerät zur Präzisionsmessung darin platziert. Wenn zum Beispiel ein Rastersondenmikroskop skaliert werden soll, muss das Gerät auf einem entsprechenden Tisch des Rastersondenmikroskops angeordnet werden, und auf die Fläche des Gerätes muss mit der Markierung der Sonden auf den Abstand des Abstandes (in der Größenordnung 0,5 nm) zwischen der oberen Sonde und der Fläche gegeben werden, bei dem das Stabilisierungssystem arbeitet. Die Stabilisierung der Sonde kann durch Stabilisierung des Tunnelstroms (beim Arbeiten unter Tunnelmikroskopierbedingungen) oder durch Stabilisierung des Wertes der Kraft, die auf die Sonden wirkt (beim Arbeiten unter Atomkraftmikroskopbedingungen), bestimmt werden. Die Stabilisierung des Abstandes wird mit einem Elektronensteuersystem bestimmt, das die Kongruenz der Signale der Messgeräte mit den gegebenen Werten und den Steuersignalen erzeugt.

Bei der Skalierung des getesteten Messgerätes in der Vertikalen wird auf die Elektroden des Gerätes zur Präzisionsbewegung, das die Verschiebung in der Vertikalen gewährleistet, eine Festspannung angelegt. Dabei wird die Fläche des Gerätes um einen Wert verschoben, der laut Skalierungstabelle bestimmt wird. Das Stabilisierungssystem des Abstandes gewährleistet eine entsprechende Verschiebung der Sonde auf den Abstand, auf den die Fläche des Musters verschoben wird. Der Wert der Verschiebung der Sonde wird mit dem Messgerät des Sondenmikroskops gemessen. Auf diese Art und Weise wird dem Wert der Anzeige der Messinstrumente des Sondenmikroskopes, die den Abstand messen und auf den die Sonde verschoben wird, der entsprechende Wert des Abstands gegenüber gestellt, der der Skalierungskurve entnommen wird, auf den die Fläche des Gerätes verschoben wird. Anschließend wird die Spannung, die am Gerät angelegt wird, verändert und der Messvorgang wiederholt. Im Ergebnis mehrfach durchgeführter Messungen bei unterschiedlichen Spannungswerten wird eine Tabelle erstellt, die das Verhältnis des Verschiebungswertes des Gerätes und der Geräteanzeige des Sondenmikroskops, das die Sondenbewegung gemessen hat, widerspiegelt.

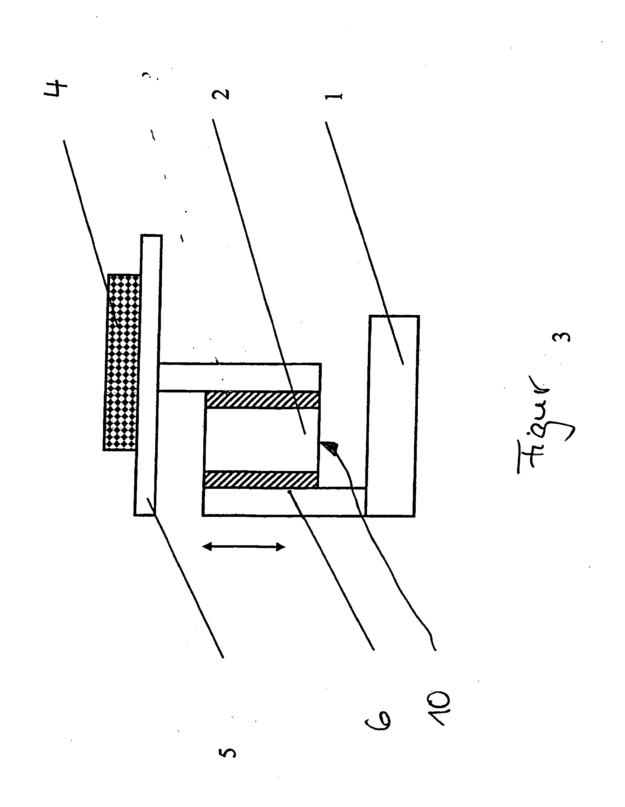

Erfindungsgemäßes Beispiel 2. Das Gerät zur Präzisionsbewegung (Abb. 3) enthält einen Boden 1, mit dem eine Platte 2 aus piezoelektrischem Werkstoff verbunden ist, auf die erfindungsgemäß auch nur uneleastische feste Elektroden 3.1, 3.2 unter Bildung des Basismoduls (10) aufgetragen sind. Die Verbindung der Platte 2 mit dem Boden 1 erfolgt mithilfe der Konsole 6. Die feste, nicht elastische Elektrode 3.2 wird mit deren vertikaler Fläche verbunden. Die zweite Elektrode 3.1 der Platte wird mit der zweiten Konsole 5 (auf der Zeichnung T-förmig dargestellt) verbunden, auf der die Lesefläche 4 befestigt wird.

Als piezoelektrischer Werkstoff kann beliebig bekannter Werkstoff, auch polykristalliner, verwendet werden. Am zweckmäßigsten ist es jedoch, Monokristalle mit geringer Hysterese und Kriechdehnung zu verwenden. Es können also Monokristalle von Lithiumniobat, Tantalum-Lithium, Strontium-Barium-Niobat, Barium-Natrium-Niobat und andere verwendet werden, die den Piezoeffekt zeigen. Auf zwei entgegen gesetzt liegende Platten 2 werden nach bekannten Methoden Elektroden 3 aus Cr, Cu oder In aufgetragen.

Das Gerät arbeitet wie folgt: Beim Anlegen einer Spannung aus einer Quelle auf Elektroden 3 (auf den Zeichnungen nicht dargestellt), wird die Platte 2 aus piezoelektrischem Werkstoff so deformiert, wie es in Abb. 2 dargestellt ist. Im Ergebnis wird die T-förmige Konsole 5 nach oben oder unten im Verhältnis zum Boden 1 bewegt, und zwar in Abhängigkeit von der angelegten Spannung.

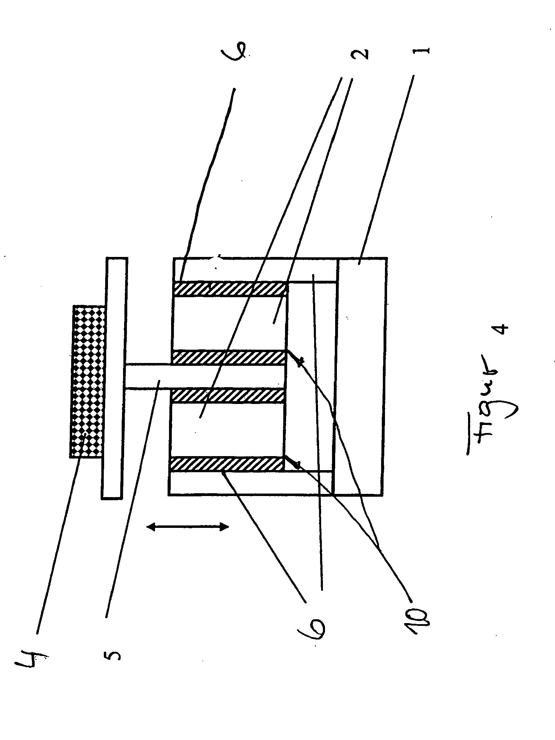

Erfindungsgemäßes Beispiel 3. Das Gerät zur Präzisionsbewegung (Abb. 4) enthält einen Boden 1, mit dem zwei identische Platten 2 aus piezoelektrischem Werkstoff verbunden sind, auf die erfindungsgemäß auch nur uneleastische feste Elektroden 3.1, 3.2 aufgetragen sind. Die Verbindung der Platten 2 mit dem Boden 1 wird mithilfe identischer Konsolen 6 bestimmt. Jede dieser Platten ist mit einer ihrer festen Elektroden 3.2 mit den vertikalen Flächen der Konsolen verbunden. Mit den zweiten Elektroden 3.1 sind die Platten mit der zweiten Konsole 5 (in der Zeichnung T-förmig dargestellt) verbunden, die sich zwischen den Platten befinden. Auf den Konsolen ist die Lesefläche 4 befestigt.

Das Gerät arbeitet wie folgt: Beim Anlegen einer Spannung aus einer Quelle auf die Elektroden 3 (auf den Zeichnungen nicht dargestellt), werden die Platten 2 aus piezoelektrischem Werkstoff so deformiert, wie es in Abb. 2 dargestellt ist. Im Ergebnis wird die T-förmige Konsole 5 im Verhältnis zum Boden 1 nach oben oder unten in Abhängigkeit von der Polarität der angelegten Spannung bewegt.

Das Gerät wird wie in Beispiel 1 beschrieben verwendet.

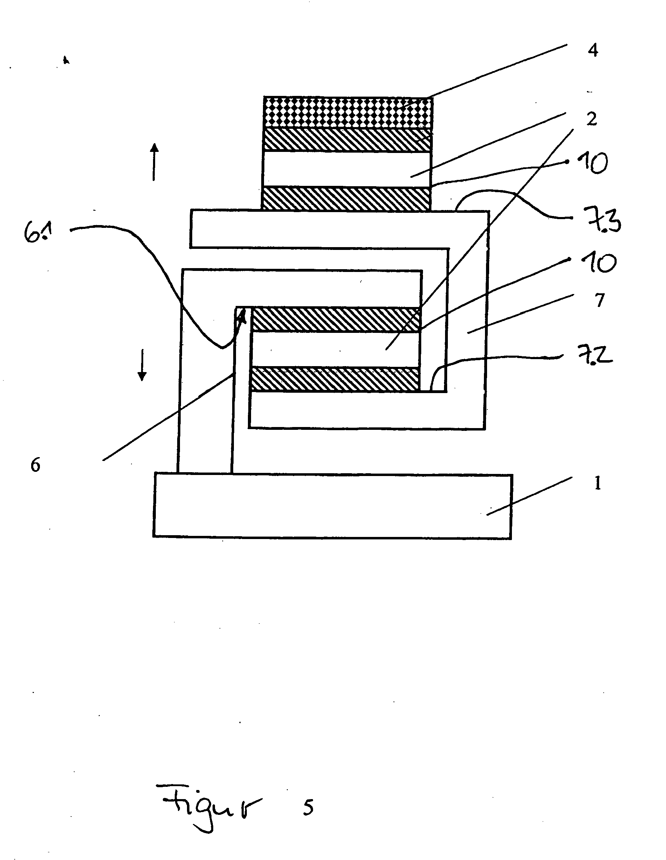

Nicht erfindungsgemäßes Beispiel 4. Das Gerät zur Präzisionsbewegung (Abb. 5) enthält einen Boden 1, mit dem zwei oder mehr identische Platten 2 aus piezoelektrischem Werkstoff verbunden sind, auf die auch nur feste unelastische Elektroden unter Bildung je eines Basismoduls 10 aufgetragen sind. Die Verbindung der Platten 2 mit dem Boden 1 wird mithilfe einer L-förmigen Konsole 6 bestimmt. Die erste (untere) Platte 2 ist mit der oberen Elektrode auf der unteren horizontalen Fläche 6.1 der ersten Konsole befestigt. Die untere Elektrode ist mit der oberen horizontalen Fläche 7.2 des unteren Kopfstückes bzw. des unteren ersten U-Schenkels der U-förmig ausgebildeten Konsole 7, verbunden. Dabei ist an der oberen Fläche 7.3 des oberen Kopfstückes bzw. oberen zweiten U-Schenkels der zweiten Konsole 7 die untere Elektrode einer zweiten (oberen) Platte 2 (weiteres Basismodul 10) aus piezoelektrischem Werkstoff, welches Basismodul 10 identisch mit dem ersten ist, vorgesehen, auf dem, und zwar auf der oberen Elektrode sich die Lesefläche 4 befindet. Die Ausrichtung des piezoelektrischen Werkstoffs in den Platten muss so erfolgen, dass beim Anlegen einer Spannung an deren Elektroden sich die untere und obere Platten in ein und dieselbe Richtung verschieben müssen, und zwar in Richtung der Fläche der Elektroden.

Das Gerät arbeitet wie folgt: Beim Anlegen einer Spannung aus einer Quelle auf die Elektroden 3 (in den Zeichnungen nicht dargestellt), werden die Platten 2 aus piezoelektrischem Werkstoff deformiert, weshalb sich die Lesefläche 4 zur Seite verschiebt. Das Gerät wird, wie in Beispiel 1 beschrieben, verwendet.

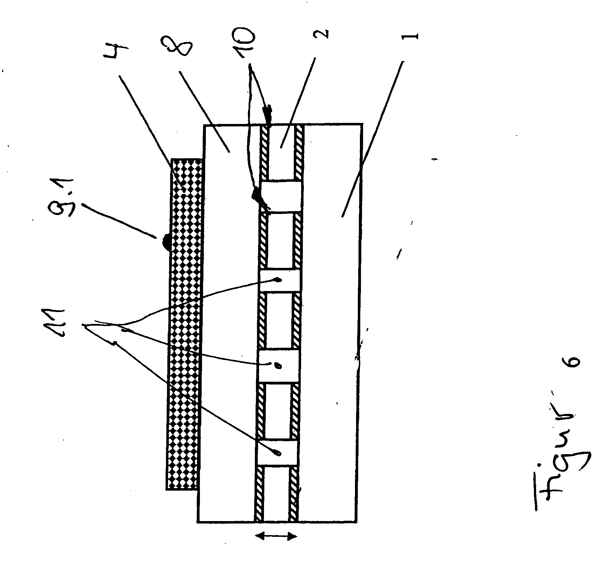

Nicht erfindungsgemäßes Beispiel 5. Das Gerät zur Präzisionsbewegung (Abb. 6) enthält einen Boden 1, mit dem eine Gruppe voneinander über je einen Zwischenraum 11 voneinander beabstandeter piezoelektrischer Platten 2 verbunden ist, von denen jede auch nur mit unelastischen festen Elektroden unter Bildung eines Basismoduls 10 ausgerüstet ist. Über den Platten befindet sich eine Zwischenschicht 8, die aus einem Werkstoff mit einem Temperaturkoeffizienten der Dehnung ausgeführt ist, der dem Temperaturkoeffizienten der Dehnung des Werkstoffs des Bodens 1 entspricht.

Das Gerät arbeitet wie folgt: Beim Anlegen einer Spannung aus einer Quelle an die Elektroden (in den Zeichnungen nicht dargestellt), werden die Platten 2 aus piezoelektrischem Werkstoff deformiert, weshalb sich die Lesefläche 4 je nach Werkstoff und Ausrichtung der Achsen des Kristallgitters, nach oben, unten oder horizontal verschiebt, und zwar in Abhängigkeit von der Polarität der angelegten Spannung. Das Gerät wird, wie in Beispiel 1 beschrieben, verwendet.

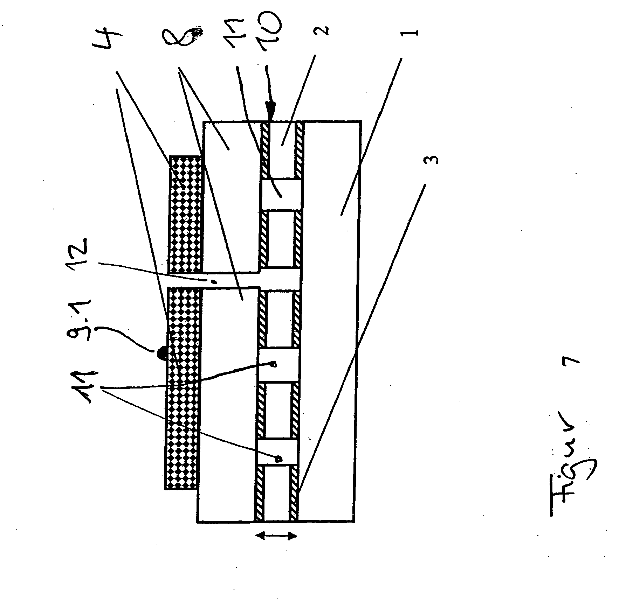

Nicht erfindungsgemäßes Beispiel 6. Das Gerät zur Präzisionsbewegung (Abb. 7) enthält einen Boden 1, mit dem eine Gruppe voneinander über je einen Zwischenraum 11 voneinander beabstandeter piezoelektrischer Platten 2 verbunden ist, von denen jede auch nur mit festen unelastischen Elektroden unter Bildung eines Basismoduls 10 ausgerüstet ist. Über den Platten befinden sich die Zwischenschichten 8, die über einen Spalt 12 voneinander getrennt sind und auf denen sich die Leseflächen 4 befinden. Die Zwischenschicht besteht aus einem Werkstoff mit einem Temperaturkoeffizienten, der mit dem Temperaturkoeffizienten der Dehnung des Werkstoffs des Bodens 1 identisch ist.

Das Gerät arbeitet wie folgt:
Beim Anlegen einer Spannung aus einer Quelle an die Elektroden der Platten 2 erfolgt eine Verschiebung der Leseflächen 4 in verschiedene Richtungen im Verhältnis zum Boden 1.

Innerhalb jedes Basismoduls verschieben sich die Piezoplatten parallel zueinander. Es sind verschiedene Richtungen der Verschiebung der Leseflächen 4 untereinander möglich:
Die Leseflächen der zweiten Gruppe verschieben sich zum Boden 1 rechtwinklig in entgegengesetzten Richtungen; oder aber sie verschieben sich parallel zum Boden in entgegengesetzten Richtungen. Auch können sich die Leseflächen 4 der Gruppen in zueinander rechtwinkligen Richtungen (eine parallel zum Boden und die zweite rechtwinklig) verschieben. Das Gerät wird, wie in Beispiel 1 beschrieben, verwendet.

## Patentansprüche

1. Gerät zur Ausführung einer Präzisionsbewegung mit einer Platte (2) aus piezoelektrischem Werkstoff und mit an zueinander entgegengesetzten sowie vorzugsweise parallelen Ebenen vorgesehenen, an eine eine gesteuerte elektrische Spannung aufweisende Spannungsquelle angeschließbar und dabei eine Änderung der Form und/oder Maße der Platte (2) bewirkenden Elektroden (3), wobei zumindest eine der Elektroden (3) elastisch unter Bildung eines Basismoduls (10) ausgebildet ist, **dadurch gekennzeichnet, dass** der Boden (1) einer ersten Konsole mit zumindest einer rechtwinklig zu dem Boden (1) verlaufenden ersten Ebene (6) und eine T-förmige zweite Konsole (5) mit einem die Schutz- oder Leseschicht bzw. -ebene (4) aufweisenden Querbalken und mit einem sich rechtwinklig zu diesem und vorzugsweise mittig dazu anschließenden Steg vorgesehen sind und dass zwischen dem Steg der zweiten Konsole (5) und der rechtwinklig zu dem Boden (1) verlaufenden Ebene (6) der ersten Konsole das Basismodul (10) angeordnet ist (Figur 3).

2. Gerät nach Anspruch 1, **dadurch gekennzeichnet, dass** die zu dem Boden (1) gehörige erste Konsole U-förmig mit einer rechtwinklig zu dem Boden (1) verlaufenden zweiten Ebene ausgebildet ist und dass zwischen dieser und dem Steg der zweiten Konsole (5) ein weiteres zu dem ersten -auch mit Bezug auf die Orientierung der Kristallachsen, bezogen auf die Achsen des Kristallgitters- identisches Basismodul (10) so vorgesehen ist, dass bei Anlage der Spannung eine Bewegung der Platten (2) in jeweils gleicher Richtung erfolgt (Figur 4).

3. Gerät nach Anspruch 1 oder 2, **dadurch gekennzeichnet, dass** die Platte (2) monokristallin aus einem Werkstoff mit, bezogen auf polykristalline Werkstoffe geringer Hysterese und/oder geringer Kriechdehnung ausgebildet ist, wobei die Orientierung der Achsen des Kristalls (Kristallachsen) bezogen auf die Achsen des Kristallgitters mit Bezug zu den die Elektroden aufweisenden Ebenen so gewählt ist, dass sich eine Änderung der Form und/oder der Maße der Platte in zu den Elektroden winkliger, d.h. in dazu rechtwinkliger und/oder paralleler überlagerter Richtung ergibt.

4. Gerät nach einem der vorhergehenden Ansprüche, **dadurch gekennzeichnet, dass** die Platte (2) als Stapel mit mehreren gestapelt angeordneten, identischen Platten (2) bzw. Basismodulen (10) ausgebildet ist, dass diese zwischen sich die Elektroden (3) aufweisen, dass alle Elektroden (3) elastisch ausgebildet sind und dass an diese (3) Spannungen (U) von jeweils gleicher Größe und Richtung angelegt sind.

## Claims

1. A device for the performance of a precision movement with a plate (2) made from piezoelectric material and with electrodes (3) provided on mutually opposing and preferably parallel surfaces capable of being connected to a voltage source providing a controlled electrical voltage and accordingly causing a change in the shape and/or dimensions of the plate (2),
wherein at least one of the electrodes (3) is embodied in an elastic manner forming a base module (10),
**characterised in that**
the base (1) of a first bracket is provided with at least one first surface (6) extending at right angles to the base (1), and a T-shaped second bracket (5) is provided with a cross-bar providing the protective layer or read-layer respective surface (4) and with a web adjoining the latter at right angles and preferably centrally to the latter,
and that the base module (10) is arranged between the web of the second bracket (5) and the surface (6) of the first bracket extending at right angles to the base (1) (Figure 3).

2. The device according to claim 1,
**characterised in that**
the first bracket associated with the base (1) is embodied in a U-shape with a second surface extending at right angles to the base (1) and that,
between the latter and the web of the second bracket (5), a further base module (10) identical to the first - also with reference to the orientation of the crystal axes relative to the axes of the crystal lattice - is provided in such a manner that upon the application of the voltage,
a movement of the plates (2) takes places in each case in the same direction (Figure 4).

3. The device according to claim 1,
**characterised in that**
the plate (2) is embodied in a mono-crystalline manner made from a material with low hysteresis and/or low creep relative to poly-crystalline materials,
wherein the orientation of the axes of the crystal (crystal axes) with reference to the axes of the crystal lattice is selected in such a manner relative to the planes providing the electrodes that a change in the shape and/or the dimensions of the plate takes place in an angular direction relative to the electrodes, that is, at right angles to the latter and/or in a parallel superposed direction.

4. The device according to any one of the preceding claims,
**characterised in that**
the plate (2) is embodied as a stack with several identical plates (2) or respectively base modules (10) arranged in a stacked manner, that the latter provide electrodes (3) between them, that all electrodes (3) are embodied in an elastic manner and that voltages (U), each of identical magnitude and direction, are applied to the latter.

## Revendications

1. Appareil permettant d'exécuter un mouvement précis, pourvu d'une plaque (2) en matériau piézoélectrique et d'électrodes (3) disposées sur des plans opposés les uns aux autres et de préférence parallèles, lesdites électrodes pouvant être raccordées à une source de tension présentant une tension électrique commandée et accomplissant ainsi une modification de la forme et/ou des dimensions de la plaque (2), au moins une des électrodes (3) étant élastique, formant ainsi un module de base (10), **caractérisé en ce que** le fond (1) d'une première console pourvu d'au moins un premier plan (6) s'étendant perpendiculairement au fond (1) et une seconde console (5) en forme de T sont pourvus d'une traverse présentant une couche protectrice ou de lecture ou un plan protecteur ou de lecture (4) et d'une entretoise se raccordant perpendiculairement à cette traverse et de préférence de manière centrale à cette dernière, et **en ce que** le module de base (10) est disposé entre l'entretoise de la seconde console (5) et le plan (6), s'étendant perpendiculairement au fond (1), de la première console (figure 3).

2. Appareil selon la revendication 1, **caractérisé en ce que** la première console associée au fond (1) est réalisée sous la forme d'un U et pourvue d'un second plan s'étendant perpendiculairement au fond (1), et **en ce qu'**un autre module de base (10) identique, également en ce qui concerne l'orientation des axes de cristal, rapportée au axes du réseau cristallin, est présent entre ce plan et l'entretoise de la seconde console (5), de telle manière que lorsqu'une tension est appliquée, un mouvement des plaques (2) s'effectue dans respectivement la même direction (figure 4).

3. Appareil selon la revendication 1 ou 2, **caractérisé en ce que** la plaque (2) présente une conception monocristalline et est faite d'un matériau présentant une hystérèse et/ou un allongement de fluage inférieurs à ceux de matériaux polycristallins, l'orientation des axes du cristal (axes du cristal) rapportée aux axes du réseau cristallin par rapport aux plans comprenant les électrodes étant choisie de telle manière que cela permet d'obtenir une modification de la forme et/ou des dimensions de la plaque dans la direction angulaire par rapport aux électrodes, c'est-à-dire dans la direction superposée perpendiculaire et/ou parallèle à celles-ci.

4. Appareil selon l'une quelconque des revendications précédentes, **caractérisé en ce que** la plaque (2) est conçue comme un empilement de plusieurs plaques (2) ou modules de base (10) identiques empilés, **en ce que** les électrodes (3) sont situées entre ces derniers ou dernières, **en ce que** toutes les électrodes (3) sont élastiques et **en ce que** des tensions (U) présentant une grandeur et une direction respectivement identiques sont appliquées sur lesdites électrodes (3).
